# EUROPEAN PATENT APPLICATION

(11) **EP 2 172 980 A1**
(43) Date of publication of application: **07.04.2010**
(21) Application number: 08805315.2
(22) Date of filing: 09.07.2008
(51) Int. Cl.: H01L 31/052

(54) **SOLAR ENERGY CONCENTRATOR AND ASSEMBLY METHOD**

(30) Priority: 10.07.2007 ES 200701933
(71) Applicant: Alejo Trevijano, José Javier, 41003 Sevilla (ES)
(72) Inventor: Alejo Trevijano, José Javier, 41003 Sevilla (ES)
(74) Representative: Ungria Lopez, Javier
(86) International application number: PCT/ES2008/000485
(87) International publication number: WO 2009/007484

(57) **Abstract**

The invention is designed to produce electric energy by means of sunlight which is received by at least one light receptor element. It is **characterized in** comprising at least one close module (1, 1') filled with water or another liquid, with at least one upper curved transparent lamellar portion (2, 2') which concentrates the sunlight; said module includes a light receptor element (3) which hangs from a vertical rod (4) connected by one end to a stationary rotation point (5). The light receptor element (3) is connected to the opposite end of the rod, and means are included to place the element at all times in the relevant position depending on the situation and orientation of the sun using a light photosensor (6) or timer.

## Description

### OBJECT OF THE INVENTION

The present invention, as the heading of this specification sets forth, is relate to a solar energy concentrator and assembly method.

It is designed to produce electric energy by at least one light receptor element immersed in a liquid fluid, such as water, that allows the light to pass through it, in such a way that this fluid is contained within a close space with at least one upper transparent portion with a curved characteristic which concentrates the light towards the light receptor element immersed in this liquid fluid.

In principle, this energy concentration is attained due to the magnifying glass effect carried out by the transparent lamellar portion and the water that makes contact with the inner face of this curved transparent lamellar portion.

### BACKGROUND OF THE INVENTION

Currently, the generation of electricity from photovoltaic cells is based on the property of semiconductor materials, which constitute them, of generating electrons when the light hits their surfaces. The light photons cause that the electrons abandon their orbits thus producing a power difference and an electric current when joining together poles of different voltages. Such photovoltaic cells are arranged in series or in parallel if more voltage or current is pretended to be attained.

The voltage produced by the cells is continuous so that in order to attain an alternative current an electronic circuit that turn the continuous current into alternative current should be applied. The voltage or electric current level is also determined by the amount of light hitting on the cell, so that the more light more electron current and therefore more electric energy,
On the other hand, cells of materials different from the semiconductor ones whose voltage value remains constant, independently from the amount of light hitting them, are being researched. This fact implies a large advance, since in the days of low light or cloudy, the voltage value remains constant.

Another parameter influencing the electric power level generated by the cells is the spectrum or the color of the light hitting the cells. The power response of the cells is different to different spectrums or colors. In function of the material or the structure, the cells behave differently in front of different color rages, so that the ideal cell would be the one having an equal and linear response against the entire light spectrum, from the infrared to the ultraviolet.

However this is difficult to attain in the implementation, so that from a white light beam, containing the entire color gamut, a single cell only use a single portion corresponding to the light frequency to which the cell is more sensitive.

Currently what is done to get a better yield is arranged thin photovoltaic sheets of different responses to the light spectrum and that together cover the entire spectrum, being stuck one on another in order to attain a higher efficient. The drawback of this method is that the sheets themselves partially obstruct the light pass.

On the other hand, the light decomposition has been experimented with a holographic filter to make the light of the different colors to hit the corresponding cell optimized for that color.

The drawback of this technique is that the focal distance or point between the filter and the light hitting point is very high, being necessary plenty space and volume for assembling a module comprising the holographic filter and the solar cells. These filters also generate two beams from the light that pass throughout them: the main beam which is still white light and the second one, thins last constituted by the color gamut of the light spectrum. Additionally, the second one is used but the main one is not.

Another technique for decomposing the light into colors is the already known one by the optic, which is based on the utilization of one or several prisms.

In regard of this technique, it is known that the NASA has conducted tests compiling a vault composed of small prisms decomposing the light into colors and making them hit on little solar cell optimized for the different wavelengths vertically aligned under the vault.

This design requires plenty space and volume while the prisms do not decompose 100% of the light reflecting In their faces thus generating yield losses, Additionally, the prisms need high light values in order to decompose the light into colors, the prim or prisms behave as if it was an opaque surface and practically no energy can be produced.

On the other hand, a photovoltaic solar plant consists of solar cells and mechanisms that help directing the plates towards the location of the sun, making the same route that the sun does along a journey.

In order to attain this, sensors and circuits are often utilized to determinate the sun position and the plates are moved by means of motors or servomotors in order to direct them toward the desire point.

The motors require strong, expensive and heavy structures, as well as a complex installation, which decisively impacts in the run times of a photovoltaic solar plant installation comprised by thousands of modules.

Other known systems which are being employing in carrying out solar plants is the use of mirror solar concentrators or Fresnel lenses, of lower cost than the photovoltaic cells, in order to focus the sunlight on the respective cells. Thereby, fewer cells are employed for the same land surface.

However, this system presents the drawback that when concentrating the light, the heat is also concentrated and the solar cells notably decrease their yield with the increase of the temperature. In summary, it can be said that currently the known solar plants are expensive, complex and difficult to be Installed and also difficult to be handled. All of this makes the photovoltaic energy not to be a feasible and real alternative, taking into account that they further depend on the meteorological conditions.

Thus, for a solar plant to be feasible and the photovoltaic energy to be a good alternative to be considered in the field of electric generation for home application, it must be low cost and quick and easy to be installed, as well as it must support to be efficient at adverse meteorological conditions.

### DESCRIPTION OF THE INVENTION

In order to achieve the objectives and avoid the drawbacks mentioned in the preceding paragraphs, the Invention proposes a solar energy concentrator characterized in comprising at least one close module filled with water or another liquid as a deposit, with at least one upper curved transparent lamellar portion which concentrates the sunlight; said module includes a light receptor element which hangs from a vertical rod connected by one end to a stationary rotation point, the light receptor element connecting to the opposite end of the rod. In addition means are included to place the mentioned receptor element at all times in the relevant position depending on the situation and orientation of the sun using a light photosensor or timer.

Another characteristic of the invention Is that the means to move and place the light receptor element according to the sun position comprise the following elements.

A float connected to the light receptor element by means of a tie rod tending to pull the light receptor element in a radial direction with respect to the stationary rotation point.

A wire associated to the light receptor element and to a servomotor that is linked to a sunlight photosensor, servomotor that when activated by the photosensor pulls the light receptor element against the float resistance until placing the light receptor element in the relevant position depending on the sun position.

Another characteristic of the invention is that the means to move and place the light receptor element in the relevant position comprise two servomotors associated to two opposite tie rods connected at their free ends to the light receptor element by two opposite points, activating said servomotors by means of two light photosensors.

Another characteristic is that the means to move and place the light receptor element according to the sun position comprise a fluid with low boiling point, so that when it becomes gas or dilates due to an increase in the temperature, the light receptor element shifts in the direction of the rotation and when it becomes liquid or contracts due to a decrease in the temperature, the rotation is then in the opposite direction.

Another characteristic of the invention is that the means to move and place the light receptor element in the relevant position comprise the following elements

A floating element shifting the light receptor element in a rotation direction trough a wire or tie road.

An arcuate and metallic sheet with different dilatation coefficients, whose upper curved-concave face is traversed by a small metallic body that makes contact with it and this one is associated to the light receptor element and the last one associated to mirrors receiving said light. By this way, a tiny elevation is caused in the contact of the small metallic body and the upper face of the bimetallic sheet due to the increase of the temperature pushing the light receptor into one direction.

In other embodiment, the means to move and place the light receptor element in the relevant position comprise the following elements.

A hollow body opened by the lower part and connected to the vertical rod by a tie rod, being said body placed at a side of the rod.

A thermometer structure with a spiral upper coil is located at the other side of the rod in the same plane. Said thermometer is in communication with the hollow body through an intermediate conduction, connecting that thermometer structure at its lowest part to the lower end of the road with interposition of a small metallic body, whose variation and temperature dilates or contracts a material located in the thermometer structure, such as mercury, alcohol, or the like, thus attaining placing the light receptor element where corresponds. This one is associated to the rod, as well as mirrors, linked to the mentioned road and light receptor element, are included.

In other embodiment, the means to move and place the light receptor element in the relevant position comprise the following elements.

A floating element shifting the light receptor element in a rotation direction trough a wire or tie road.

A hollow body opened by the lower part and connected to the vertical rod by a tie rod, being said body placed at the opposite side of the float floating element, although in the same plane.

An lower chamber associated to a small metallic body linked to the rod and whose variation and temperature dilates or contracts the air in that chamber that is in communication with the hollow body though a conduit, varying the position of the light receptor element connected to the rod, several mirrors linked to the rod and light receptor element are included.

In other embodiment of the invention the concentrator comprises a succession of modules formed from a transparent elongated lamellar body and by parallel successive folds of this lamellar body constituting the different modules, incorporating floating and rigidizing elements in the folding areas for installing the modules on the water-free surface of a swamp, pool or any other water extension, being these modules closed by their sides.

This succession of floating modules are anchored to the bottom by a elongated cable, this set of modules being able to rotate around said cable in order to search the most suitable orientation, in real time, with respect to the sun. This set of modules could be anchored to another stationary point.

In other embodiment of the invention each one of the concentrator modules comprises a box-lid structure, wherein at least the lid of curved configuration is transparent in order to allow the pass of the sunlight concentrating the light radiation.

In this case the lid incorporates in its highest area a through hole closed by a small plug, hole designed to be filled with transparent liquid and to release the air of possible upper air chambers which may obstruct of decrease the yield of the concentrator.

Other characteristic of the invention is that the upper transparent lamellar portions of the modules incorporate electric-acoustic transducers that emit sounds and/or ultrasounds in order to avoid the insects or other elements that prevent or reduce the ability of the sunlight to pass through these transparent lamellar portions. These electric-acoustic transducers are stationed on the exterior face of the transparent lamellar portions.

The light receptor elements can comprise photoelectric cells or comprise independent sets, each of which would be formed by a collimator, a diffracter and a cell optimized to different light spectrums,

On the other hand, one of the electric poles of the photocell will be in direct contact with the water that is acting as electricity conductor while a second conductor cable makes contact with the water surface in order to direct the electrical current to the exterior of the swamp, pool or water deposit.

The assembly method of the solar energy concentrator is **characterized in that** it mounts from a transparent lamellar body located in a vessel and which is extending by the rear part of the vessel forming the different modules and incorporating the intermediate floating elements located in the folds of separation of each module, also closing the side portions of each module, also incorporating the rest of the elements.

Finally, In regard to the assembly process, it must also be noted that the transparent sheet will be arranged in the vessel as a roll making its extension and mounting easier,

Next, to facilitate a better understanding of this specification, and being an integral part thereof, figures in which the object of the invention has been represented with an illustrative and not limitative manner are attached.

### BRIEF DESCRIPTION OF THE DRAWINGS

**Figure 1****. -** Shows a view of the solar energy concentrator, object of the Invention. It basically comprises a simple concentrator determined by a close module as a deposit filled with water with a transparent and curved upper lid which allows the pass of the light toward the interior wherein, among other elements, a light receptor, as well as means for placing, in real time, the light receptor in accordance to the sun position are placed.
**Figure 2****. -** Shows other view similar to the previous one with some variations.
**Figure 3****. -** Shows a view wherein particular means to place the light receptor wherein participate two motor-reducers, are shown.
**Figure 4****.** - Shows other embodiment of the means to place the light receptor with the required orientation.
**Figures 5 to 7****.** - Show other means to place the light receptor with the required orientation, the light receptor that is always housed inside the water of the module or corresponding deposit.
**Figure 8****. -** Shows a view of the succession of the simple modules.
**Figures 9** **and** **10****.** -Show other embodiment of the invention comprising several successive modules with light receptors. The assembly process from a continuous transparent sheet in the shape of a roll, which is in the vessel just as the rest of the necessary elements, is also shown.

### DESCRIPTION OF THE PREFERRED EMBODIMENT

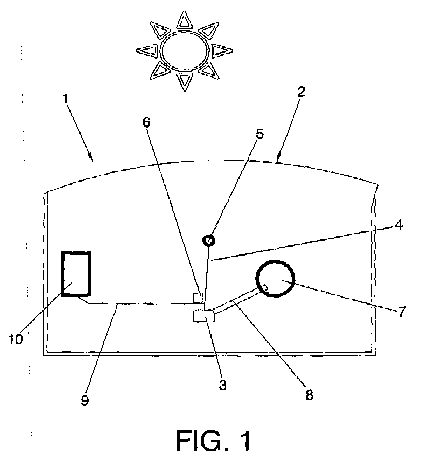

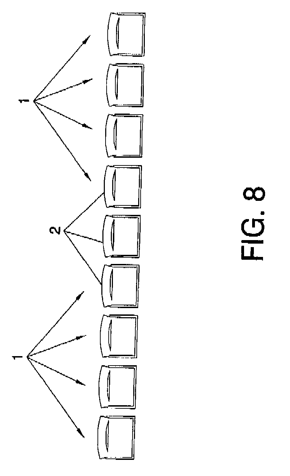

Considering the numbering adopted in figures 1 to 8, the solar energy concentrator is determined from one or several close modules 1 as deposits, in principle, comprising a bottom and several side walls, as well as an upper transparent lid 2 with curved configuration, such that this lid 2 together with the water volume which occupies the entire interior space of each module 1, make the lens function thus concentrating the light towards a light receptor 3 also located within the deposit, whose side walls and bottom are also preferably transparent

This light receptor 3 hangs from the lower end of a vertical rod 4 connected by its opposite upper end to a stationary rotation point 5. Means to place this light receptor 3 at all times In the relevant position depending on the situation and orientation of the sun with a light photosensor 6 or timer, not represented in the figures, are also included.

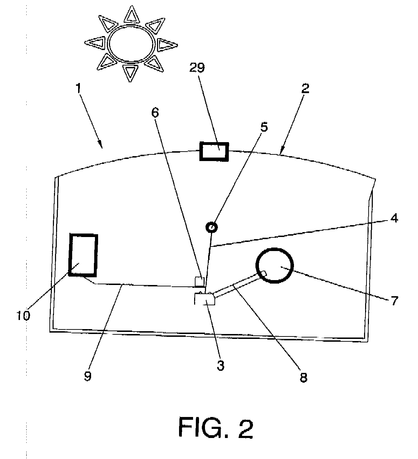

In the embodiment showed in figures 1 and 2, for example, the means to move and place the light receptor element 3 according to the sun position, comprise a float 7 connected to the light receptor element 3 by a tie rod 8 that tends to pull the light receptor element 3 in a rotation direction with respect to the stationary rotation point 5.

Said means also comprise a wire 9 associated to the light receptor element 3 and to a servomotor 10, which can also be linked to the sunlight photosensor 6, the servomotor 10 when activated by said photosensor 6 pulls the light receptor element 3 against the float 7 resistance until placing the light receptor element 3 in the relevant orientation depending on the position of the sun.

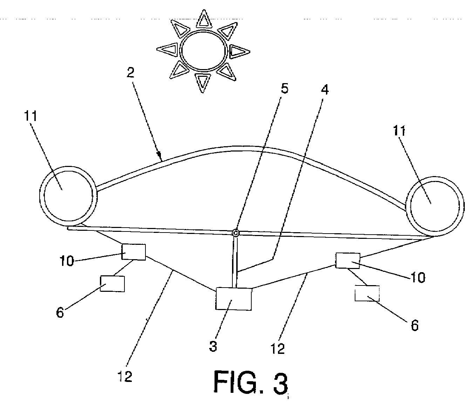

In other embodiment showed in figure 3, the means to move and place the light receptor element 3 in the relevant position comprise two servomotors 11 associated to two opposite tie rods 12 connected at their free ends to the light receptor element 3 by two opposite points, activating said servomotors 11 by two light photosensors 6.

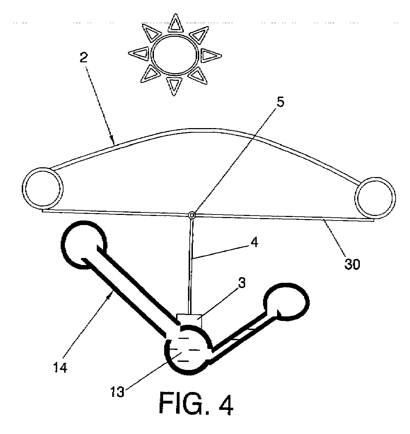

In other embodiment of the invention showed in figure 4, the means to move and place the light receptor according to the sun position comprise a fluid with a low boiling point 13, so that when it becomes gas or dilates due to a increase in the temperature, the light receptor element 3 shifts in a rotation direction and when it becomes liquid or contracts due to a decrease in the temperature, the rotation is then in the opposite direction, The fluid with low boiling point is located in an angular conduit 14 with a central chamber and two extreme chambers.

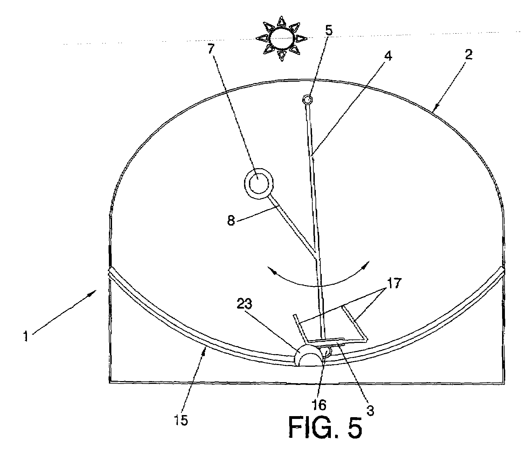

In other embodiment showed in figure 5, the means to move and place the light receptor element 3 in the relevant position, comprise a floating element 7 shifting the light receptor element 3 in a rotation direction through a wire, rod or tie rod 4. These means further comprise an arcuate and bimetallic sheet 15 with different dilatation coefficients, whose upper curved-concave face is traversed by a small metallic body 16 which makes contact thereof and that is associated to the light receptor element 3 and these one is associated to several light receptor mirrors 17, obtaining a tiny elevation 23 when the small metallic body 16 makes contact with the upper face of the metallic sheet 15 due to the increase in the temperature that pushes the light receptor element 3 into a direction.

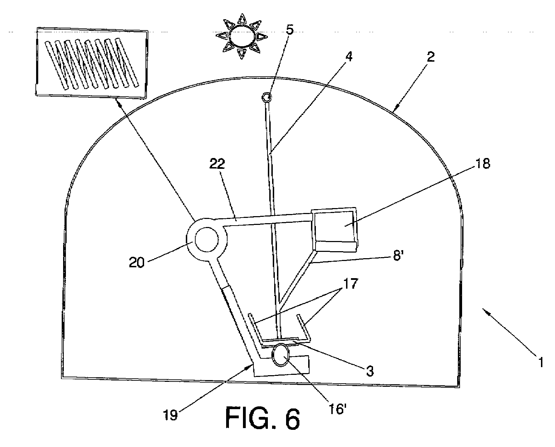

In other embodiment of the invention showed in figure 6, the means to move and place the light receptor element 3 in the relevant position, comprise a hollow body 18 opened at the lower part and connected to a vertical rod 4 by a tie rod 8', the hollow body 18 placed at one side of the rod 4. These means further include a thermometer structure 19 with a spiral upper coil located at the other side of the rod 4 in the same plane, which is in communication with the hollow body 18 though a conduction 22, this thermometer structure 19 is connected at its lowest part to the lower end of the rod 4 with the interposition of a small metallic body 16' whose temperature variation dilates or contracts a material located in the thermometer structure 19, such as mercury, alcohol, or the like, thus attaining placing the light receptor element 3 where corresponds. This one will be associated to the rod 4, while mirrors 17 linked to the mentioned rod 4 and light receptor element 3 are included.

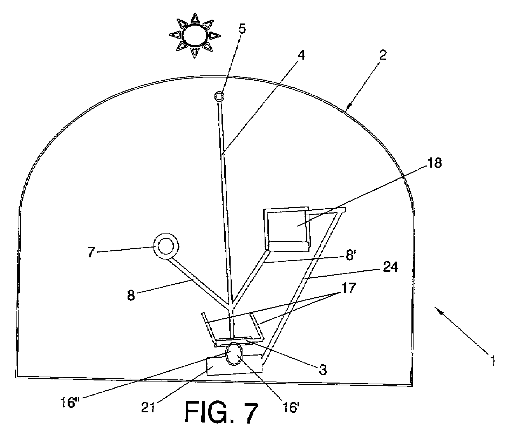

In other embodiment showed in figure 7, the means to move and place the light receptor element 3 in the relevant position, comprise a floating element 7 shifting the light receptor element 3 in a rotation direction through a wire or tie rod 8. Such means further include a hollow body 18 opened at the lower part and connected to the vertical rod 4 by a tie rod 8', said hollow body 18 is placed at the opposite side of the floating element 7, although in the same plane. Said means also include a lower chamber 21 associated to a small metallic body 16" linked to the rod 4 and whose temperature variation dilates or contracts the air of the lower chamber 21 which is in communication with the hollow body 18 through a conduit 24, varying the position of the light receptor element 3 connected to the rod 4, several mirrors 17 linked to the mentioned rod 4 and the light receptor element 3 are included.

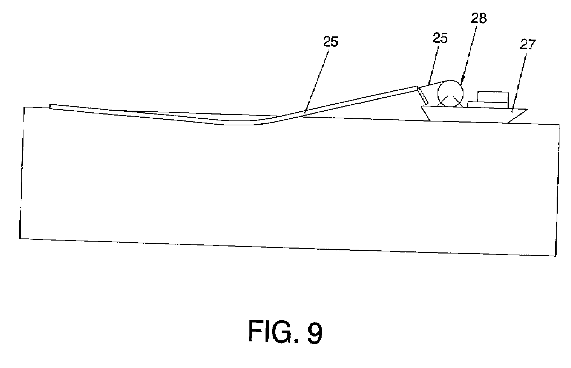

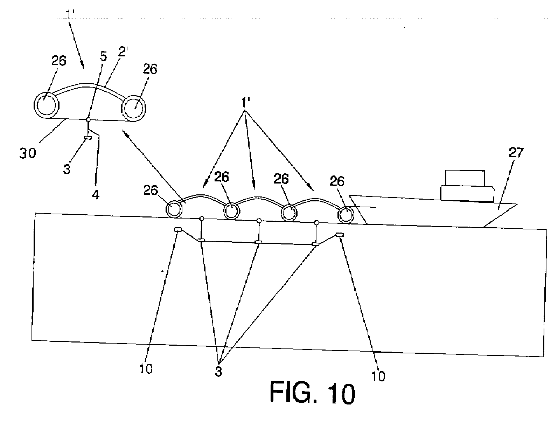

Other way to apply the solar concentrator regarding figures 9 and 10, consists of a succession of modules 1' formed from a transparent elongated lamellar body 25 and by parallel successive folds of this lamellar body 25, thus forming the different modules with transparent curved portions 2'. In the folding areas that separate several modules 1 from others, floating and rigidizing elements 26 are incorporated for installing the modules on the water-free surface of a swamp, pool or any other water extension, such modules 1' are closed at their sides. Additionally, the floating elements can be associated by lower tie rods 30 in order to maintain with greater security the distance of the floats 26 and also in order to secure the formation of the solar concentrator set structure.

This light concentrator is constituted from a transparent sheet 25, that is mounted from a transparent lamellar body located in a vessel 27 and which is extending by the rear part of the mentioned vessel 27 thus forming the different modules 1' and incorporating the intermediate floating elements 26 located in the folds of separation of each module 1', also closing the side portions of each module 1', also incorporating the rest of the elements. It should be also noted that the sheet will be arranged in the vessel preferably as a roll 28.

On the other hand, each module can be formed from a box-lid structure 2, wherein at least the curved configuration lid is transparent in order to allow the pass of the sunlight while concentrating the light radiation.

The lid 2 incorporates in its highest area a through hole closed with a plug 29, the hole is designed to be filled with transparent liquid and to release the air of possible air upper chambers.

The mentioned transparent lamellar portions of the modules incorporate several electric-acoustic transducers that emit sounds and/or ultrasounds in order to avoid insects or other elements that prevent or reduce the ability of the sunlight to pass through these transparent lamellar portions.

Such electric-acoustic transducers are stationary on the exterior face of the transparent lamellar portions.

The light receptor elements 3 can comprise photoelectric cells and also independent sets. Each one of these sets is formed by a collimator, a diffracter and a cell optimized to different light spectrums.

## Claims

1. **SOLAR ENERGY CONCENTRATOR,** designed to produce electric energy by means of sunlight which is received by at least one light receptor element, **characterized in that** it comprises at least one close module (1, 1') filled with water or another liquid, with at least one upper curved transparent lamella portion (2, 2') which concentrates the sunlight; said module includes a light receptor element (3) which hangs from a vertical rod (4) connected by one end to a stationary rotation point (5), the light receptor element (3) is connected to the opposite end of the rod, including means to place the element at all times in the relevant position depending on the situation and orientation of the sun using a light photosensor (6) or timer.

2. **SOLAR ENERGY CONCENTRATOR**, according to claim 1, **characterized in that** the means to move and place the light receptor element (3) according to the position of the sun comprise:
- a float (7) connected to the light receptor element (3) by a tie rod (8) that tends to pull the light receptor element (3) in a rotation direction with respect to the stationary rotation point (5);
- a wire (9) associated to the light receptor element (3) and to a servomotor (10) that is linked to the sunlight photosensor (6), the servomotor (10) when activated by said photosensor (6) pulls the light receptor element (3) against the float (7) resistance until placing the light receptor element (3) in the relevant orientation depending on the position of the sun.

3. **SOLAR ENERGY CONCENTRATOR,** according to claim 1, **characterized in that** the means to move and place the light receptor element (3) in the relevant position comprise two servomotors (11) associated to two opposite tie rods (12) connected at their free ends to the light receptor element (3) by two opposite points, activating said servomotors (11) by two light photosensors (6).

4. **SOLAR ENERGY CONCENTRATOR,** according to claim 1, **characterized in that** the means to move and place the light receptor element (3) according to the position of the sun comprise a fluid with a low boiling point (13), so that when it becomes gas or dilates due to a increase in the temperature, the light receptor element (3) shifts in a rotation direction and when it becomes liquid or contracts due to a decrease In the temperature, the rotation is then in the opposite direction.

5. **SOLAR ENERGY CONCENTRATOR,** according to claim 1, **characterized in that** the means to move and place the light receptor element (3) In the relevant position comprise:
- a floating element (7) shifting the light receptor element (3) in a rotation direction through a wire or tie rod (8);
- an arcuate bimetallic sheet (15) with different dilatation coefficients, whose upper curved-concave face is traversed by a small metallic body (16) which makes contact thereof and that is associated to the light receptor element (3) and these one is associated to several light receptor mirrors (17), obtaining a tiny elevation (23) when the small metallic body (16) makes contact with the upper face of the bimetallic sheet (15) due to an Increase in the temperature that pushes the light receptor element (3) into a direction.

6. **SOLAR ENERGY CONCENTRATOR,** according to claim 1, **characterized in that** the means to move and place the light receptor element (3) in the relevant position comprise:
- a hollow body (18) opened at the lower part and connected to a vertical rod (4) by a tie rod (8'), the hollow body (18) placed at one side of the mentioned rod (4);
- a thermometer structure (19) with a spiral upper coil located at the other side of the rod (4) in the same plane, which is in communication with the hollow body (18) though an intermediate conduction (22), this thermometer structure (19) is connected at its lowest part to the lower end of the rod (4) with the interposition of a small metallic body (16'), whose temperature variation dilates or contracts a material located In the thermometer structure (19), such as mercury, alcohol, or the like, thus attained placing the light receptor element (3) where corresponds, this one is associated to the rod (4), while mirrors (17) linked to the mentioned rod (4) and light receptor element (3) are included.

7. **SOLAR ENERGY CONCENTRATOR,** according to claim 1, **characterized in that** the means to move and place the light receptor element (3) in the relevant position comprise:
- a floating element (7) shifting the light receptor element (3) in a rotation direction through a wire or tie rod (8);
- a hollow body (18) opened at the lower part and said hollow body (18) is placed at the opposite side of the floating element (7) although in the same plane;
- a lower chamber (21) associated to a small metallic body (16") linked to the rod (4) and whose temperature variation dilates or contracts the air of the lower chamber (21) which is in communication with the hollow body (18) through a conduit (24), varying the position of the light receptor element (3) connected to the rod (4), several mirrors (17) linked to the rod (4) and the light receptor element (3) are included.

8. **SOLAR ENERGY CONCENTRATOR,** according to claim 1, **characterized in that** it comprises a succession of modules (1') formed from a transparent elongated lamellar body (25) and by parallel successive folds of this lamellar body (25) the different modules (1') are constituted, incorporating floating and rigidizing elements in the folding areas (26) for installing the modules (1') on the water-free surface of a swamp, pool or any other water extension, the modules (1') are closed at their sides.

9. **SOLAR ENERGY CONCENTRATOR,** according to claim 1, **characterized in that** each module (1) comprises a box-lid structure wherein at least the curved configuration lid (2) is transparent in order to allow the pass of the sunlight while concentrating the light radiation.

10. **SOLAR ENERGY CONCENTRATOR,** according to claim 9, **characterized in that** the lid (2) incorporates in its highest area a through hole closed with a small plug (29), the hole is designed to be filled with transparent liquid and to release the air of possible air upper chambers.

11. **SOLAR ENERGY CONCENTRATOR,** according to any one of the previous claims, **characterized in that** the upper transparent lamellar portions (2, 2') of the modules (1, 1') incorporate several electric-acoustic transducers that emit sounds and/or ultrasounds in order to avoid insects from alighting or other elements that prevent or reduce the ability of the sunlight to pass through these transparent lamellar portions (2, 2').

12. **SOLAR ENERGY CONCENTRATOR,** according to claim 11, **characterized in that** the electric-acoustic transducers are stationary on the exterior face of the transparent lamellar portions (2, 2').

13. **SOLAR ENERGY CONCENTRATOR,** according to any one of the previous claims, **characterized in that** the light receptor elements (3) comprise photoelectric cells.

14. **SOLAR ENERGY CONCENTRATOR,** according to any one of the claims 1 to 12, **characterized in that** the light receptor elements (3) comprise independent sets, each one of them is formed by a collimator, a diffracter and a cell optimized to different light spectrums.

15. **SOLAR ENERGY CONCENTRATOR,** according to any one of the claims 1 to 13, **characterized in that** one of the electric poles of the photocell (6) is in direct contact with the water that is acting as electricity conductor and the second conductor cable makes contact with the water surface in order to direct the electrical current to the exterior of the swamp, pool or any other water extension

16. **ASSEMBLY METHOD OF A SOLAR ENERGY CONCENTRATOR,** according to claim 8, **characterized in that** the concentrator is mounted from a transparent lamellar body (25) located in a vessel (27) and which is extending by the rear part of the vessel (27) forming the different modules (1') and incorporating the intermediate floating elements (26) located in the folds of separation of each module (1'), also closing the side portions of each module (1'), also incorporating the rest of the elements.

17. **ASSEMBLY METHOD OF A SOLAR ENERGY CONCENTRATOR,** according to claim 16, **characterized in that** the transparent sheet (25) is arranged in the vessel (27) as a roll (28),
